# EUROPÄISCHE PATENTSCHRIFT

(11) **EP 0 740 235 B1**
(45) Veröffentlichungstag und Bekanntmachung des Hinweises auf die Patenterteilung: **29.03.2000**
(21) Anmeldenummer: 96106298.1
(22) Anmeldetag: 22.04.1996
(51) Int. Cl.: G05B 19/042, H05K 7/14

(54) **Peripheriesystem**
Peripheral system
Système périphérique

(30) Priorität: 26.04.1995 DE 29507045 U
(43) Veröffentlichungstag der Anmeldung: 30.10.1996
(73) Patentinhaber: SIEMENS AKTIENGESELLSCHAFT, 80333 München (DE)
(72) Erfinder: Knauer, Detlev, 76863 Herxheim (DE)

(56) Entgegenhaltungen:
- DE-A- 4 223 193
- DE-A- 4 323 440
- DE-C- 4 410 171

## Beschreibung

Die Erfindung betrifft ein Peripheriesystem mit Steckplätzen gemäß dem Oberbegriff des Anspruchs 1.

Ein derartiges Peripheriesystem ist aus der DE-OS 43 23 440 bekannt. Ein Gehäuse mit steckbaren Digitalein- und -ausgabemodulen ist zu den Aktoren und Sensoren am Prozeß verlagert, und es ist lediglich nur eine Anschaltungsbaugruppe in einem Automatisierungsgerät erforderlich, welche über ein Kabel mit dem dezentralen Peripheriesystem verbunden ist. Dadurch wird ein hoher Ausbaugrad erzielt, und es brauchen im Automatisierungsgerät keine Ein- und Ausgabekomponenten vorgesehen werden. Dieses bekannte Peripheriesystem hat den Nachteil, daß für jeden Ein-/Ausgabeanschluß ein sogenanntes 1er-Modul, d. h. ein Ein-/Ausgabe-, ein Eingabe- oder ein Ausgabemodul, vorgesehen werden muß, mit welchem lediglich ein Ein-/Ausgabeanschluß ansteuerbar ist. In vielen Fällen ist es allerdings vorteilhaft, auch ein sogenanntes 2er-Modul einzusetzen, mit welchem zwei Ein-/Ausgabeanschlüsse ansteuerbar sind.

Der Erfindung liegt die Aufgabe zugrunde, ein Peripheriesystem zu schaffen, in welchem Mehrfach-Module steckbar sind. Dabei soll lediglich ein Steckplatz für den Betrieb eines Mehrfach-Moduls erforderlich sein.

Diese Aufgabe wird durch die im kennzeichnenden Teil des Anspruchs 1 angegebenen Maßnahmen gelöst.

Vorteilhaft ist, daß ein Anwender je nach Anforderung einer Steuerungsaufgabe z. B. 1er- oder 2er-Module einsetzen kann. Dabei wird ein Steckverbinder und eine Leiterplatte eingespart, wenn anstatt zwei 1er-Modulen ein 2er-Modul einsetzbar ist.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
Figur 1 ein dezentrales Peripheriesystem und
Figur 2 eine Busplatine eines Peripheriesystems.

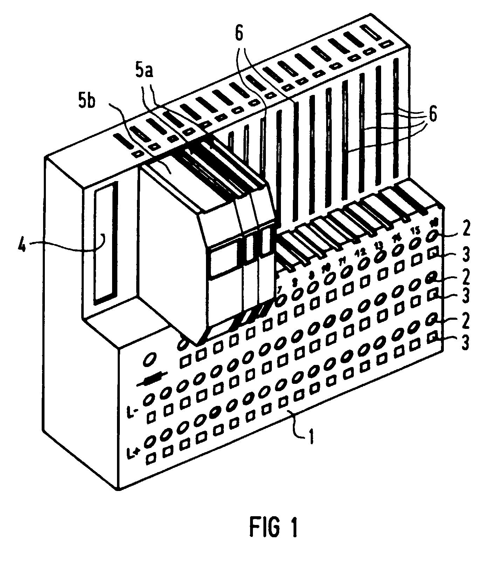

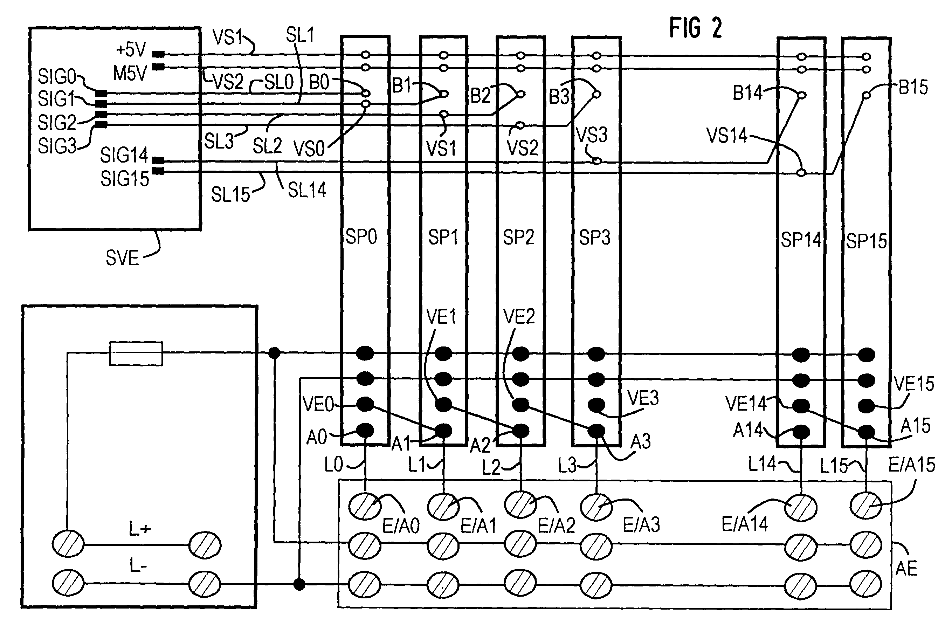

In Figur 1 ist ein Gehäuse 1 eines dezentralen Peripheriesystems dargestellt, welches mit drei Reihen von Öffnungen 2 versehen ist. Diese Öffnungen 2 weisen schraubenlose Federklemmen zum Anschluß von externen Leitungen auf, die über Betätigungsöffnungen 3 lösbar sind. In Steckplätze 6 des Gehäuses 1 sind zwei ler-Digitalein- und -ausgabemodule und ein 2er-Digitalein- und -ausgabemodul 5a, 5b gesteckt, wobei die Eingänge der Module mit dem Kabelanschluß 4 und deren Ausgänge mit den Öffnungen 2 durch eine hier nicht dargestellte Busplatine im Gehäuse 1 verbunden sind. Jedes der Module 5a, 5b belegt einen Steckplatz 6. Am linken Ende der Reihe von Öffnungen 2 sind mit L- und L+ bezeichnete Öffnungen für Potentialleitungen angebracht, die zur Zuführung der Potentialleitungen auf ein Sicherungsmodul mit einer von vorne austauschbaren Sicherung dienen. An den Kabelanschluß 4 ist ein Flachbandkabel anschließbar, welches das dezentrale Peripheriesystem 1 mit einer Signalverarbeitungsanschaltung 7 eines Automatisierungsgerätes verbindet. Jedem Steckplatz 6 sind drei Öffnungen 2 zugeordnet, an welche Aktoren oder Sensoren mit einem Dreileiter-Anschluß anschließbar sind. Jeweils zwei dieser drei Öffnungen 2 sind zum Anschluß eines Sensors/Aktors an die Potentialleitungen L+, L-, eine Öffnung (Figur 2, E/A0, E/A1, ...) ist für den Anschluß einer Signalleitung vorgesehen, welche mit diesem Sensor/Aktor verbunden ist. Im vorliegenden Beispiel umfaßt das dezentrale Peripheriesystem sechzehn Steckplätze 6 mit sechzehn Öffnungen 2. Daher weist das am Kabelanschluß 4 anzuschließende Flachbandkabel insgesamt achtzehn Leitungen auf, von denen sechzehn Leitungen für die Signalübertragung zwischen der Anschaltung und den gesteckten Modulen und zwei Leitungen für eine Spannungsversorgung +5 V, M5 V vorgesehen sind. Aus der Spannungsversorgung +5 V, M5 V werden die Versorgungsspannungen L+, L- für die angeschlossenen Sensoren/Aktoren gebildet. Über den Federklemmen ist ein Beschriftungsfeld angeordnet, auf dem Kennzeichnungen 1 ... 16 (1 ... 6 in Figur 1 verdeckt) der einzelnen Anschlüsse untergebracht sind.

In Figur 2 ist eine Busplatine eines Peripheriesystems dargestellt, die sechzehn Steckplätze SP0, SP1 ... SP15 umfaßt. Die Steckplätze SP0, ... sind mit Anschlüssen versehen, von denen erste Anschlüsse A0 ... A15 zum Anschluß jeweils einer Ein-/Ausgabeleitung L0, L1 ... L15 und zweite Anschlüsse B0, B1 ... B15 zum Anschluß von Stichleitungen SL0, SL1 ... SL15 vorgesehen sind. Die Stichleitungen SL0, ... sind an eine Signalverarbeitungsanschaltung SVE eines Automatisierungsgerätes angeschlossen, welche hier nicht dargestellte, auf den Steckplätzen SP0, ... gesteckte Ein-/Ausgabemodule mit Signalen SIG0 ... SIG15 in Form eines "0"- oder "1"-Pegels versorgt oder welche von diesen Modulen entsprechende Signale empfängt. Die Ein-/Ausgabeleitungen sind an Ein-/Ausgabeanschlüsse E/A0, E/A1 ... E/A15 einer Anschlußeinheit AE geführt, an welche jeweils eine Signalleitung zum Anschluß eines Sensors oder Aktors anschließbar ist. Die Steckplätze SP0, ... und die Anschlußeinheit AE sind mit weiteren Anschlüssen versehen, an welche Versorgungsleitungen VS1, VS2 und die Potentialleitungen L+, L- angeschlossen sind. Die dargestellte Busplatine ist derart ausgebildet, daß sowohl 1er- als auch 2er-Module beliebig in einen Steckplatz steckbar sind. Dazu sind sowohl Anschlüsse VS0, VS1 ... VS14 der Steckplätze SP0 ... SP14 mit den ersten Anschlüssen A1 ... A15 und somit mit den Stichleitungen SL1 ... SL15 als auch Anschlüsse VE0, VE1 ... VE14 der Steckplätze SP0, ... mit den zweiten Anschlüssen B1, B2 ... B15 und somit mit den Ein-/Ausgabeleitungen L1, L2 ... L15 verbunden. Das bedeutet im vorliegenden Beispiel, daß zu jedem Steckplatz SP0 ... SP14 die Stichleitung SL1 ... SL15 und die Ein-/Ausgabeleitung L1 ... L15 des jeweiligen nächsten Steckplatzes SP1 ... SP15 geführt ist. Die geometrischen Abmessungen eines 2er-Moduls entsprechen denen zweier benachbarter 1er-Module. Dadurch ist gewährleistet, daß neben einem gesteckten 2er-Modul kein 1er-Modul gesteckt werden kann, was sicherstellt, daß ein Ein-/Ausgabeanschluß nur von einem Modul angesteuert wird. Ein in einen der Steckplätze SP0 ... SP14 gestecktes 2er-Modul weist entsprechende Verbindungsmittel zum Kontaktieren mit den jeweiligen Anschlüssen VE0 ... VE14 und VS0 ... VS14 des Steckplatzes auf. Z. B. ein in den Steckplatz SP1 gestecktes Modul ist mit Verbindungsmitteln zum Kontaktieren mit den Anschlüssen A1 und B1 versehen und weist ferner Verbindungsmittel zum Kontaktieren mit den Anschlüssen VE1 und VS1 auf. In die Steckplätze SP0 ... SP14 sind im vorliegenden Beispiel 1er- und 2er-Module beliebig steckbar, der Steckplatz SP15 ist lediglich für ein 1er-Modul vorgesehen. Es ist selbstverständlich möglich, die Busplatine derart auszubilden, daß z. B. auch 3er-Module einsetzbar sind. Dazu ist es erforderlich, daß die Steckplätze jeweils weitere Anschlüsse für die Stichleitung und die Ein-/Ausgabeleitung des jeweiligen übernächsten Steckplatzes aufweisen. Z. B. muß der Steckplatz SP0 Anschlüsse zum Anschluß der Stichleitung SL2 und der Ein-/Ausgabeleitung L2 aufweisen, damit ein solches 3er-Modul in dem Steckplatz SP0 betrieben werden kann. Dabei muß dieses 3er-Modul mit entsprechenden Verbindungsmitteln zum Kontaktieren mit diesen Anschlüssen und den Anschlüssen VE1 und VS1 versehen sein.

## Patentansprüche

1. Peripheriesystem mit Steckplätzen (SP0, SP1, ...),
- welche jeweils über einen ersten Anschluß (A0, A1, ...) des Steckplatzes (SP0, SP1, ...) und über eine Ein-/Ausgabeleitung (L0, L1, ...) mit einem Ein-/Ausgabeanschluß (E/A0, E/A1, ...) verbunden sind, an welchen ein Sensor oder Aktor anschließbar ist,
- welche jeweils über einen zweiten Anschluß (B0, B1, ...) des Steckplatzes (SP0, SP1, ...) an eine Stichleitung (SL0, SL1, ...) einer Signalverarbeitungsanschaltung (SVE) anschließbar sind und
- in die jeweils ein Ein- und/oder Ausgabemodul steckbar ist, welches mit dem ersten und zweiten Anschluß (A0, A1, ...; B0, B1, ...) kontaktiert,
**dadurch gekennzeichnet,**
- daß an Anschlüsse (VS0, VS1, ...; VE0, VE1, ...) mindestens eines Steckplatzes (SP0, ...) mindestens die Stichleitung (SL1, SL2, ...) und die Ein-/Ausgabeleitung (L1, L2, ...) des nächsten Steckplatzes (SP1, SP2, ...) anschließbar ist und
- daß ein gestecktes Ein- und/oder Ausgabemodul mit Verbindungsmitteln zum Kontaktieren mit den Anschlüssen (VS0, VS1, ...; VE0, VE1, ...) versehen ist.

2. Automatisierungssystem mit einem Peripheriesystem nach Anspruch 1.

## Claims

1. Peripheral system having plug-in stations (SP0, SP1, ...),
- which are each connected by way of a first terminal (A0, A1, ...) of the plug-in station (SP0, SP1, ...) and by way of an input/output line (L0, L1, ...) to an input/output terminal (E/A0, E/A1, ...), to which a sensor or actuator can be connected,
- which can each be connected by way of a second terminal (B0, B1, ...) of the plug-in station (SP0, SP1, ...) to a spur line (SL0, SL1, ...) of a signal-processing interface connection (SVE), and
- into which a respective input and/or output module can be plugged that makes contact with the first and second terminal (A0, A1, ...; B0, B1, ...),
characterised
- in that at least the spur line (SL1, SL2, ...) and the input/output line (L1, L2, ...) of the next plug-in station (SP1, SP2, ...) can be connected to terminals (VS0, VS1, ...; VE0, VE1,...) of at least one plug-in station (SP0, ...), and
- in that an inserted input and/or output module is provided with connection means for making contact with the terminals (VS0, VS1, ...; VE0, VE1, ...).

2. Automation system having a peripheral system according to claim 1.

## Revendications

1. Système périphérique comportant des emplacements d'enfichage (SP0, SP1, ...),
- qui sont reliés respectivement par l'intermédiaire d'une première connexion (A0, A1, ...) de l'emplacement d'enfichage (SP0, SP1, ...) et par l'intermédiaire d'une ligne d'entrée/sortie (L0, L1, ...) à une connexion d'entrée/sortie (E/A0, E/A1, ...) à laquelle un capteur ou un actionneur peut être connecté,
- qui peuvent être connectés respectivement par l'intermédiaire d'une deuxième connexion (B0, B1, ...) de l'emplacement d'enfichage (SP0, SP1, ...) à une ligne de branchement (SL0, SL1, ...) d'un circuit de traitement de signal (SVE) et
- dans lesquels peut être enfiché respectivement un module d'entrée et/ou de sortie qui est mis en contact avec la première et la deuxième connexion (A0, A1, ... ; B0, B1, ...),
caractérisé par le fait
- qu'il peut être connecté à des connexions (VS0, VS1, ... ; VE0, VE1, ...) d'au moins un emplacement d'enfichage (SP0, ...) au moins la ligne de branchement (SL1, SL2, ...) et la ligne d'entrée/sortie (L1, L2, ...) de l'emplacement d'enfichage suivant (SP1, SP2, ...) et
- qu'un module d'entrée et/ou de sortie enfiché est muni de moyens de liaison pour assurer le contact avec les connexions (VS0, VS1, ... ; VE0, VE1, ...).

2. Système d'automatisation comportant un système périphérique selon la revendication 1.
